(19) Europäisches Patentamt
European Patent Office
Office européen des brevets

(11) **EP 4 625 833 A1**

(12) **EUROPEAN PATENT APPLICATION**

(43) Date of publication:
**01.10.2025 Bulletin 2025/40**

(21) Application number: **25165685.6**

(22) Date of filing: **24.03.2025**

(51) International Patent Classification (IPC):
***H04B 3/56*** (2006.01)

(52) Cooperative Patent Classification (CPC):
**H04B 3/56**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.03.2024 JP 2024051111**

(71) Applicant: **MegaChips Corporation Osaka 532-0003 (JP)**

(72) Inventor: **SATO, Yohei Osaka, 532-0003 (JP)**

(74) Representative: **Winter, Brandl - Partnerschaft mbB Alois-Steinecker-Straße 22 85354 Freising (DE)**

(54) **COMMUNICATION SYSTEM**

(57)     An impedance upper is provided between one unit out of a control unit and a driving unit, and a cable. An insulator is provided between one communication unit out of communication units, and the cable. Between the one communication unit and the cable, a matching circuit that includes a coil of the impedance upper and a capacitor of the insulator, and reduces reflection of a communication signal in an end portion of the cable is provided.

Alternatively, an insulator is provided between the one communication unit and the cable. A filter circuit is provided between the insulator and the one communication unit. Between the one communication unit and the cable, a matching circuit that includes a coil of the insulator and a capacitor of the filter circuit, and reduces reflection of a communication signal at an end portion of the cable, is formed.

*FIG.1*

EP 4 625 833 A1

**Description**

BACKGROUND

Technical Field

The present disclosure relates to a communication system that supplies power and executes communication.

Description of Related Art

In a communication system including a control device and a driving device, power is supplied from the control device to the driving device. Further, the control device and the driving device communicate with each other. With this configuration, since the control device and the driving device are connected by various cables, the size of the connection structure between the control device and the driving device is likely to increase.

SUMMARY

For example, JP 2007-150621 A discloses a technique in regard to power line communication. Signal reflection caused by impedance mismatch may occur between a terminal device disclosed in JP 2007-150621 A and a power line. In this case, good communication cannot be executed through the power line. Therefore, it is preferable to provide a filter for maintaining impedance matching between the terminal device and a cable. However, when such a filter is newly added to a control device of JP 2007-150621 A, the size of the connection structure between the terminal device and the power line is increased. Therefore, it is required to reduce the size of the connection structure between the devices.

An object of the present disclosure is to provide a communication system with which devices can communicate with each other well while an increase in size of a connection structure is prevented.

A communication system according to one aspect of the present disclosure provided in a control system that includes a control circuitry configured to supply power through a cable having a predetermined characteristic impedance and a driving circuitry configured to receive power that is supplied through the cable, includes a first communication circuitry and a second communication circuitry configured to respectively receive or transmit communication signals indicating communication information through the cable from or to each other, a first impedance upper that is provided between one circuitry out of the control circuitry and the driving circuitry, and the cable, increases an impedance between the one circuitry and the cable, and includes a first coil, and a first insulator that is provided between one communication circuitry out of the first communication circuitry and the second communication circuitry, and the cable, insulates the one communication circuitry from power supplied by the control circuitry, and includes a first capacitor, wherein a first matching circuit that includes the first coil and the first capacitor and reduces reflection of the communication signal in an end portion of the cable is formed between the one communication circuitry and the cable.

A communication system according to another aspect of the present disclosure provided in a control system that includes a control circuitry configured to supply power through a cable having a predetermined characteristic impedance and a driving circuitry configured to receive power that is supplied through the cable, includes a first communication circuitry and a second communication circuitry configured to respectively receive or transmit communication signals indicating communication information through the cable from or to each other, a first insulator that is provided between one communication circuitry out of the first communication circuitry and the second communication circuitry, and the cable, insulates the one communication circuitry from power supplied by the control circuitry, and includes a first coil, and a first filter circuit that is provided between the first insulator and the one communication circuitry and includes a first capacitor, wherein a first matching circuit that includes the first coil and the first capacitor and reduces reflection of the communication signal in an end portion of the cable is formed between the one communication circuitry and the cable.

With the present disclosure, devices can communicate with each other well while an increase in size of a connection structure is prevented.

BRIEF DESCRIPTION OF THE DRAWING

Fig. 1 is a diagram showing the configuration of a control system including a communication system according to a first embodiment of the present disclosure;
Fig. 2 is a diagram showing the configuration of one interface circuit;
Fig. 3 is a diagram showing the configuration of another interface circuit;
Fig. 4 is a diagram showing the configuration of a control device in a first modified example;

Fig. 5 is a diagram showing the configuration of a communication system according to another embodiment; and
Fig. 6 is a diagram showing the configuration of a control device in a second modified example.

DETAILED DESCRIPTION

1. First Embodiment

(1) Configuration of Communication System

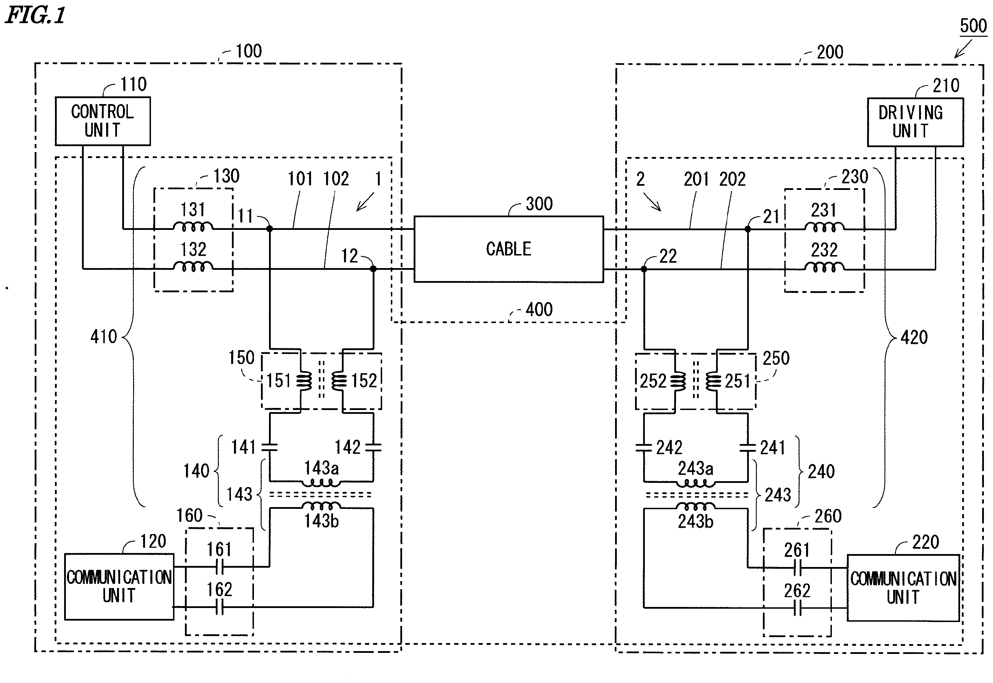

A communication system according to embodiments of the present disclosure will be described below in detail with reference to the drawings. Fig. 1 is a diagram showing the configuration of a control system including a communication system according to a first embodiment of the present disclosure. As shown in Fig. 1, the control system 500 includes a control device 100, a driving device 200 and a cable 300. The control system 500 is a servo motor system, for example. In this case, the control device 100 is a servo amplifier, and the driving device 200 is a servo motor. The cable 300 is a cable including two wires and is used to connect the control device 100 to the driving device 200. The cable 300 has a predetermined characteristic impedance (75 Ω in the present example).

The control device 100 includes a control unit 110, a communication unit 120, an impedance upper 130, an insulator 140, a CMCC (Common Mode Choke Coil) 150 and a filter circuit 160. The control unit 110 is connected to one end portion of one wire of the cable 300 by a wire 101, and is connected to one end portion of the other wire of the cable 300 by a wire 102. The control unit 110 includes a CPU (Central Processing Unit) and a power supply device, for example.

The control unit 110 generates a PWM (Pulse Width Modulation) voltage having an amplitude of several hundred volts and a frequency of several tens of kHz, an AC voltage or a DC voltage of several volts to several tens of volts, for example. Further, the control unit 110 supplies power for driving a driving unit 210, described below, of the driving device 200 to the driving unit 210 through the wires 101, 102 and the cable 300. The control system 500 may include a three-phase cable that connects the control unit 110 to the driving unit 210 in addition to the cable 300. In this case, the control unit 110 may supply AC power or a PWM voltage for driving the driving unit 210 to the driving unit 210 through the three-phase cable. In a case in which the control system 500 includes a three-phase cable in addition to the cable 300, the control unit 110 may supply power required by the driving unit 210 to the driving unit 210 through the cable 300 in addition to the AC power for driving the driving unit 210. For example, the control unit 110 may supply power to an encoder included in the driving unit 210 through the cable 300.

The communication unit 120 includes a PLC (Power Line Communication) modem, for example, and receives or transmits a communication signal indicating communication information through the wires 101, 102 and the cable 300. Thus, the communication unit 120 communicates with a communication unit 220, described below, of the driving device 200. The communication information includes information used for controlling the driving unit 210 such as an operation state of the driving unit 210. In the present example, the center frequency of the communication signal is several tens of MHz.

The impedance upper 130 includes coils 131, 132. The coil 131 is provided between a node 11 in the wire 101, and the control unit 110. The coil 132 is provided between a node 12 in the wire 102, and the control unit 110. The impedances of the portions where the coils 131, 132 are provided in the wires 101, 102 increase. Thus, communication signals to be output to the wires 101, 102 by the communication unit 120 are prevented from being input to the control unit 110.

The insulator 140 includes capacitors 141, 142 and an insulating transformer 143. The insulating transformer 143 includes coils 143a, 143b that are wound around cores and electrically insulated from each other. One end portion of the coil 143a of the insulating transformer 143 is connected to the node 11 of the wire 101 through the capacitor 141. The other end portion of the coil 143a of the insulating transformer 143 is connected to the node 12 of the wire 102 through the capacitor 142. Both end portions of the coil 143b of the insulating transformer 143 are connected to the communication unit 120. Thus, the communication unit 120 is insulated from the power supplied by the control unit 110.

The CMCC 150 includes two coils 151, 152 having equal number of turns around cores. The coil 151 is provided between the capacitor 141 of the insulator 140, and the node 11 of the wire 101. The coil 152 is provided between the capacitor 142 of the insulator 140, and the node 12 of the wire 102. Thus, a common-mode noise of the communication signal output by the communication unit 120 is removed.

The filter circuit 160 is a high-pass filter and includes capacitors 161, 162. The filter circuit 160 may be a band-pass filter having a cutoff frequency in the vicinity of the center frequency of the communication signal. The capacitor 161 is provided between one end portion of the coil 143b of the insulator 140, and the communication unit 120. The capacitor 162 is provided between the other end portion of the coil 143b of the insulator 140, and the communication unit 120. Thus, a signal having a relatively low frequency, such as power supplied by the control unit 110, is prevented from being input to the communication unit 120.

The driving device 200 includes the driving unit 210, the communication unit 220, an impedance upper 230, an insulator 240, a CMCC 250 and a filter circuit 260. The driving unit 210 is connected to the other end portion of one wire of the cable 300 by a wire 201, and is connected to the other end portion of the other wire of the cable 300 by a wire 202. The driving unit 210 includes a motor body, for example, and is driven when power is supplied through the cable 300. The communication unit 220 includes a PLC modem, for example, and communicates with the communication unit 120 of the control device 100 by receiving or transmitting a communication signal through the wires 201, 202 and the cable 300.

The impedance upper 230 includes coils 231, 232. The coil 231 is provided between a node 21 in the wire 201, and the driving unit 210. The coil 232 is provided between a node 22 in the wire 202, and the driving unit 210. The impedances of the portions where the coils 231, 232 are provided in the wires 201, 202 increase. Thus, communication signals to be output to the wires 101, 102 by the communication unit 220 are prevented from being input to the driving unit 210.

The insulator 240 includes capacitors 241, 242 and an insulating transformer 243. The insulating transformer 243 includes coils 243a, 243b that are wound around cores and electrically insulated from each other. One end portion of the coil 243a of the insulating transformer 243 is connected to the node 21 of the wire 201 through the capacitor 241. The other end portion of the coil 243a of the insulating transformer 243 is connected to the node 22 of the wire 202 through the capacitor 242. Both ends portions of the coil 243b of the insulating transformer 243 are connected to the communication unit 220. Thus, the communication unit 220 is insulated from the power supplied by the control unit 110.

The CMCC 250 includes two coils 251, 252 having equal number of turns around cores. The coil 251 is provided between the capacitor 241 of the insulator 240, and the node 21 of the wire 201. The coil 252 is provided between the capacitor 242 of the insulator 240, and the node 22 of the wire 202. Thus, a common-mode noise of the communication signal output by the communication unit 220 is removed.

The filter circuit 260 is a high-pass filter and includes capacitors 261, 262. The filter circuit 260 may be a band-pass filter having a cutoff frequency in the vicinity of the center frequency of the communication signal. The capacitor 261 is provided between one end portion of the coil 243b of the insulator 240, and the communication unit 220. The capacitor 262 is provided between the other end portion of the coil 243b of the insulator 240, and the communication unit 220. Thus, a signal having a relatively low frequency, such as power supplied by the control unit 110, is prevented from being input to the communication unit 220.

(2) Communication System

The communication system 400 includes the communication units 120, 220, the impedance uppers 130, 230, the insulators 140, 240 and the filter circuits 160, 260. In the communication system 400, a matching circuit 410 that reduces reflection of a communication signal at one end portion of the cable 300 is formed between the communication unit 120 and the cable 300. Further, the communication unit 120, a load other than the matching circuit 410 between the communication unit 120 and the cable 300, and the matching circuit 410 form an interface circuit 1. Similarly, between the communication unit 220 and the cable 300, a matching circuit 420 that reduces reflection of a communication signal at the other end portion of the cable 300 is formed. Further, the communication unit 220, a load other than the matching circuit 420 between the communication unit 220 and the cable 300, and the matching circuit 420 form an interface circuit 2.

In the present embodiment, the matching circuit 410 includes the coils 131, 132 of the impedance upper 130 and the capacitors 141, 142 of insulator 140. Each of the coils 131,132 and the capacitors 141, 142 has a circuit constant that causes the impedance of the interface circuit 1 to match the characteristic impedance of the cable 300. Specifically, each of the coils 131, 132 and the capacitors 141, 142 is defined to have a circuit constant that, at the center frequency of a communication signal, causes the real part of the complex impedance of the interface circuit 1 to coincide with the characteristic impedance of the cable 300 and causes the imaginary part of the complex impedance of the interface circuit 1 to be 0.

Similarly, in the present embodiment, the matching circuit 420 includes the coils 231, 232 of the impedance upper 230 and the capacitors 241, 242 of the insulator 240. Each of the coils 231, 232 and the capacitors 241, 242 has a circuit constant that causes the impedance of the interface circuit 2 to coincide with the characteristic impedance of the cable 300. Specifically, each of the coils 231, 232 and the capacitors 241, 242 is defined to have a circuit constant that, at the center frequency of a communication signal, causes the real part of the complex impedance of the interface circuit 2 to coincide with the characteristic impedance of the cable 300 and causes the imaginary part of the complex impedance of the interface circuit 2 to be 0.

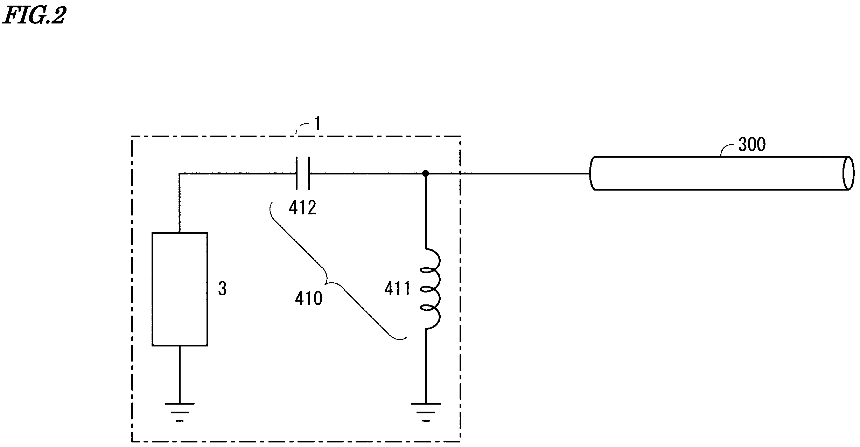

Fig. 2 is a diagram showing the configuration of the one interface circuit 1. The interface circuit 1 of Fig. 2 is shown as an equivalent circuit of the interface circuit 1 of Fig. 1. As shown in Fig. 2, the interface circuit 1 includes the matching circuit 410 and a load 3. Further, the matching circuit 410 includes a coil 411 and a capacitor 412. In the present example, because communication information is transmitted by a differential method using the wires 101, 102 of Fig. 1, the coil 411 is equivalent to each of the coils 131, 132, and the capacitor 412 is equivalent to each of the capacitors 141, 142.

In the interface circuit 1, the coil 411 is connected in parallel to the capacitor 412 and the load 3 that are connected in series. In this case, a complex admittance $Y_1$ (a reciprocal of the complex impedance) of the interface circuit 1 is expressed by the following formula (1). Further, $R_{p1}$ of the formula (1) is expressed by the following formula (2), and $X_{p1}$ is expressed by the following formula (3).

[Formula 1]

$$Y_1 = \frac{1}{j2\pi f L_1} + \frac{1}{\frac{1}{j2\pi f C_1} + R_1 + jX_1}$$
$$= \frac{1}{R_{p1}} + \frac{1}{jX_{p1}} + \frac{1}{j2\pi f L_1} \qquad \cdots (1)$$

[Formula 2]

$$R_{p1} = R_1 + \frac{\left(X_1 - \frac{1}{2\pi f C_1}\right)^2}{R_1} \qquad \cdots (2)$$

[Formula 3]

$$X_{p1} = \frac{R_1{}^2}{X_1 - \frac{1}{2\pi f C_1}} + X_1 - \frac{1}{2\pi f C_1} \qquad \cdots (3)$$

Here, f is the center frequency of a communication signal. $L_1$ is the inductance of the coil 411 (each of the coils 131, 132). $C_1$ is the electrostatic capacity of the capacitor 412 (each of the capacitors 141, 142). $R_1$ and $X_1$ are respectively the real part and the imaginary part of the complex impedance of the load 3. The complex impedance of the load 3 can be measured by an impedance measurer.

$C_1$ is defined such that, at the center frequency of a communication signal, the real part of the complex impedance of the interface circuit 1, that is, the reciprocal of the real part of the formula (1), coincides with the characteristic impedance of the cable 300. Further, $L_1$ is defined such that, at the center frequency of the communication signal, the imaginary part of the formula (1) (the imaginary part of the complex impedance of the interface circuit 1 to be specific) is 0. Therefore, when the characteristic impedance of the cable 300 is $R_H$, $C_1$ is expressed by the following formula (4), and $L_1$ is expressed by the following formula (5).

[Formula 4]

$$C_1 = \frac{1}{2\pi f \left(\sqrt{R_1 R_H - R_1{}^2} + X_1\right)} \qquad \cdots (4)$$

[Formula 5]

$$L_1 = -\frac{1}{2\pi f} \left(\frac{R_1{}^2}{X_1 - \frac{1}{2\pi f C_1}} + X_1 - \frac{1}{2\pi f C_1}\right) \qquad \cdots (5)$$

When the capacitor 412 and the coil 411 have the circuit constants respectively expressed by the formulas (4) and (5), the standing wave ratio in the cable 300 can be set to 1, and reflection of the communication signal at the end portion of the cable 300 can be prevented. As examples of numerical values, in a case in which f is 70 MHz, $R_1$ is 40 Ω, $X_1$ is 10 Ω, and $R_H$ is 75 Ω, $C_1$ is defined to be about 48 pF based on the formula (4), and $L_1$ is defined to be about 182 nH based on the formula (5).

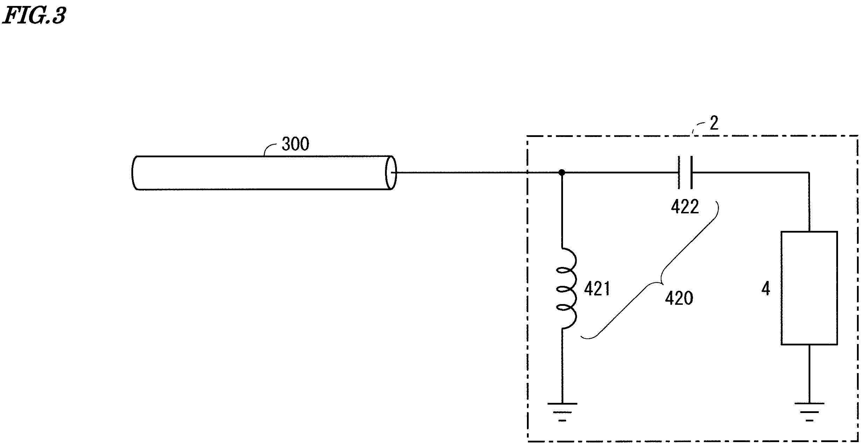

Fig. 3 is a diagram showing the configuration of the other interface circuit 2. The interface circuit 2 of Fig. 3 is shown as an equivalent circuit of the interface circuit 2 of Fig. 1. As shown in Fig. 3, the interface circuit 2 includes the matching circuit 420 and a load 4. Further, the matching circuit 420 includes a coil 421 and a capacitor 422. In the present example, because communication information is transmitted by the differential method using the wires 201, 202 of Fig. 1, the coil 421 is equivalent to each of the coils 231, 232, and the capacitor 422 is equivalent to each of the capacitors 241, 242.

In the interface circuit 2, the coil 421 is connected in parallel to the capacitor 422 and the load 4 which are connected in series. Here, similarly to the interface circuit 1, the inductance of the coil 421 (each of the coils 231, 232) is $L_2$, the electrostatic capacity of the capacitor 422 (each of the capacitors 241, 242) is $C_2$, and the complex impedance of the

load 4 is $R_2 + jX_2$. In this case, $C_2$ is expressed by the following formula (6), and $L_2$ is expressed by the following formula (7). When the capacitor 422 and the coil 421 respectively have circuit constants expressed by the formula (6) and the formula (7), the standing wave ratio in the cable 300 can be set to 1, and reflection of a communication signal at the end portion of the cable 300 can be prevented.

[Formula 6]

$$C_2 = \frac{1}{2\pi f \left( \sqrt{R_2 R_H - R_2{}^2} + X_2 \right)} \qquad \cdots (6)$$

[Formula 7]

$$L_2 = -\frac{1}{2\pi f} \left( \frac{R_2{}^2}{X_2 - \frac{1}{2\pi f C_2}} + X_2 - \frac{1}{2\pi f C_2} \right) \qquad \cdots (7)$$

(3) Effects

In the communication system 400 according to the present embodiment, the driving unit 210 of the driving device 200 is driven when power is supplied by the control unit 110 of the control device 100 through the cable 300 having a predetermined characteristic impedance. The communication unit 120 of the control device 100 and the communication unit 220 of the driving device 200 respectively receive or transmit communication signals indicating communication information from or to each other.

The impedance upper 130 that increases the impedance between the control unit 110 and the cable 300 and includes the coils 131, 132 is provided between the control unit 110 and the cable 300. The insulator 140 that insulates the communication unit 120 from the power supplied by the control unit 110 and includes the capacitors 141, 142 is provided between the communication unit 120 and the cable 300. The matching circuit 410 that includes the coil 411 (each of the coils 131, 132) and the capacitor 412 (each of the capacitors 141, 142) and reduces reflection of a communication signal at one end portion of the cable 300 is formed between the communication unit 120 and the cable 300.

With this configuration, the coils 131, 132 of the impedance upper 130 and the capacitors 141, 142 of the insulator 140 form the matching circuit 410. That is, it is possible to form the matching circuit for reducing reflection of a communication signal at the one end portion of the cable 300 by utilizing the circuit configuration for the impedance upper and the circuit configuration for insulation. Thus, the control device 100 and the driving device 200 can communicate with each other well while an increase in size of the connection structure of the communication system 400 is prevented.

The communication unit 120, the load 3 other than the matching circuit 410 between the communication unit 120 and the cable 300, and the matching circuit 410 form the interface circuit 1. Each of the coil 411 (each of the coils 131, 132) and the capacitor 412 (each of the capacitors 141, 142) of the matching circuit 410 has a circuit constant that causes the impedance of the interface circuit 1 to match the characteristic impedance of the cable 300. In this case, the matching circuit 410 can easily reduce reflection of a communication signal at the one end portion of the cable 300.

Specifically, each of the coil 411 and the capacitor 412 has a circuit constant that, at the center frequency of a communication signal, causes the real part of the complex impedance of the interface circuit 1 to coincide with the characteristic impedance of the cable 300 and causes the imaginary part of the complex impedance of the interface circuit 1 to be 0. In this case, reflection of a communication signal at the one end portion of the cable 300 can be more reliably reduced by the matching circuit 410.

Further, the impedance upper 230 which increases the impedance between the driving unit 210 and the cable 300 and includes the coils 231, 232 is provided between the driving unit 210 and the cable 300. The insulator 240 that insulates the communication unit 220 from the power supplied by the control unit 110 and includes the capacitors 241, 242 is provided between the communication unit 220 and the cable 300. The matching circuit 420 that includes the coil 421 (each of the coils 231, 232) and the capacitor 422 (each of the capacitors 241, 242) and reduces reflection of a communication signal at the other end portion of the cable 300 is formed between the communication unit 220 and the cable 300.

In this case, the coils 231, 232 of the impedance upper 230 and the capacitors 241, 242 of the insulator 240 form the matching circuit 420. That is, it is possible to form the matching circuit for reducing reflection of a communication signal at the other end portion of the cable 300 by utilizing the circuit configuration for the impedance upper and the circuit configuration for insulation. Thus, the control device 100 and the driving device 200 can communicate with each other better while an increase in size of the connection structure of the communication system 400 is prevented.

The communication unit 220, the load 4 other than the matching circuit 420 between the communication unit 220 and the cable 300, and the matching circuit 420 form the interface circuit 2. Each of the coil 421 (each of the coils 231, 232)

and the capacitor 422 (each of the capacitors 241, 242) has a circuit constant that causes the impedance of the interface circuit 2 to coincide with the characteristic impedance of the cable 300. In this case, the matching circuit 420 can easily reduce reflection of a communication signal at the other end portion of the cable 300.

Specifically, each of the coil 421 and the capacitor 422 has a circuit constant that, at the center frequency of a communication signal, causes the real part of the complex impedance of the interface circuit 2 to coincide with the characteristic impedance of the cable 300 and causes the imaginary part of the complex impedance of the interface circuit 2 to be 0. In this case, the matching circuit 420 can more reliably reduce reflection of a communication signal at the other end portion of the cable 300.

(4) Modified Example

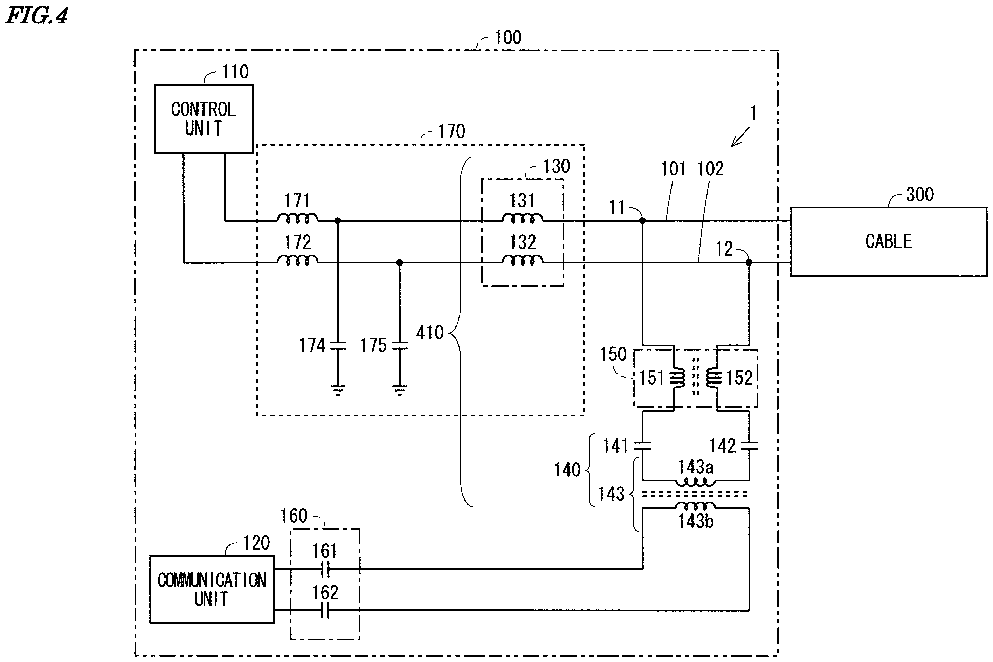

Fig. 4 is a diagram showing the configuration of a control device 100 in a first modified example. As shown in Fig. 4, in the present example, the control device 100 further includes a low-pass filter 170. The low-pass filter 170 includes coils 171, 172 and capacitors 174, 175, and also includes coils 131, 132. That is, the coils 131, 132 of the impedance upper 130 forms part of the low-pass filter 170.

The low-pass filter 170 is provided between a control unit 110 and a communication unit 120. Specifically, the coil 171 is connected between the coil 131 and the control unit 110. The coil 172 is connected the coil 132 and the control unit 110. The capacitor 174 is connected between the portion between the coils 131, 171, and the ground potential. The capacitor 175 is connected between the portion between the coils 132, 172, and the ground potential. With this connection, the low-pass filter 170 forms a third-order low-pass filter. The capacitors 174, 175 may be connected between a portion between the coils 131, 171 in a wire 101, and a portion between the coils 132, 172 in a wire 102.

In this manner, in the communication system 400 according to the first modified example, the low-pass filter 170 is provided between the control unit 110 and the communication unit 120. The coils 131, 132 form part of the low-pass filter 170. In this case, part of the low-pass filter 170 is formed by the coils 131, 132 of the impedance upper 130. The high-frequency component of the power supplied by the control unit 110 is prevented from being input to the communication unit 120. As a result, the control device 100 and a driving device 200 can communicate with each other better while an increase in size of the connection structure of the communication system 400 is prevented.

The low-pass filter 170 is a high-order low-pass filter, and further includes the coils 171, 172 and the capacitors 174, 175. The coil 171 is connected between the coil 131 and the control unit 110. The coil 172 is connected between the coil 132 and the control unit 110. The capacitor 174 is connected between the portion between the coils 131, 171, and the ground potential. The capacitor 175 is connected between the portion between the coils 132, 172, and the ground potential. In this case, the high-frequency component of the power supplied by the control unit 110 is more reliably prevented from being input to the communication unit 120.

2. Second Embodiment

In the first embodiment, the circuit constants of the coil 411 (each of the coils 131, 132) and the capacitor 412 (each of the capacitors 141, 142) are defined such that the impedance of the interface circuit 1 matches the characteristic impedance of the cable 300. Further, the circuit constants of the coil 421 (each of the coils 231, 232) and the capacitor 422 (each of the capacitors 241, 242) are defined such that the impedance of the interface circuit 2 matches the characteristic impedance of the cable 300. However, the embodiment is not limited to this.

The circuit constants of other circuit elements provided in the interface circuit 1 may be defined such that the impedance of the interface circuit 1 matches the characteristic impedance of the cable 300. Similarly, the circuit constants of other circuit elements provided in the interface circuit 2 may be defined such that the impedance of the interface circuit 2 matches the characteristic impedance of the cable 300.

For example, the interface circuit 1 includes the insulating transformer 143 of the insulator 140 and the capacitors 161, 162 of the filter circuit 160 in addition to the coils 131, 132 of the impedance upper 130 and the capacitors 141, 142 of the insulator 140. Further, the interface circuit 2 includes the insulating transformer 243 of the insulator 240 and the capacitors 161, 162 of the filter circuit 260 in addition to the coils 231, 232 of the impedance upper 230 and the capacitors 241, 242 of the insulator 240.

As such, in the present embodiment, the matching circuit 410 is formed with the coil 411 of the interface circuit 1 being equivalent to the coil 143a or the coil 143b of the insulating transformer 143 and with the capacitor 412 being equivalent to each of the capacitors 161, 162 of the filter circuit 160. Further, the matching circuit 420 is formed with the coil 421 of the interface circuit 2 being equivalent to the coil 243a or the coil 243b of the insulating transformer 243 and with the capacitor 422 being equivalent to each of the capacitors 261, 262 of the filter circuit 260. A method of defining the circuit constants of the circuit elements of the matching circuits 410, 420 in the present embodiment is similar to a method of defining the circuit constants of the circuit elements of the matching circuits 410, 420 in the first embodiment.

In this manner, in a communication system 400 according to the present embodiment, an insulator 140 that insulates a communication unit 120 from the power supplied by a control unit 110 and has the insulating transformer 143 including the coils 143a, 143b is provided. The filter circuit 160 including the capacitors 161, 162 is provided between the insulator 140 and the communication unit 120. The matching circuit 410 that includes the coil 411 (the coil 143a or the coil 143b) and the capacitor 412 (each of the capacitors 161, 162) and reduces reflection of a communication signal at the end portion of the cable 300 is formed between the communication unit 120 and the cable 300.

With this configuration, the matching circuit 410 is formed by the coils 143a, 143b of the insulator 140 and the capacitors 161, 162 of the filter circuit 160. That is, it is possible to form the matching circuit for reducing reflection of a communication signal at one end portion of the cable 300 by utilizing the circuit configuration for insulation and the circuit configuration for the filter circuit. Thus, the control device 100 and the driving device 200 can communicate with each other well while an increase in size of the connection structure of the communication system 400 is prevented. Further, it is possible to freely set the circuit constants of the coils 131, 132 and the capacitors 141, 142 forming the matching circuit 410 in the first embodiment by executing impedance matching using the coils 143a, 143b and the capacitors 161, 162.

The communication unit 120, the load 3 other than the matching circuit 410 between the communication unit 120 and the cable 300, and the matching circuit 410 form the interface circuit 1. Each of the coil 411 (the coil 143a or the coil 143b) and the capacitor 412 (each of the capacitors 161, 162) of the matching circuit 410 has a circuit constant that causes the impedance of the interface circuit 1 to match the characteristic impedance of the cable 300. In this case, the matching circuit 410 can easily reduce reflection of a communication signal at the end portion of the cable 300.

Specifically, each of the coil 411 and the capacitor 412 has a circuit constant that, at the center frequency of a communication signal, causes the real part of the complex impedance of the interface circuit 1 to coincide with the characteristic impedance of the cable 300 and causes the imaginary part of the complex impedance of the interface circuit 1 to be 0. In this case, the matching circuit 410 can more reliably reduce reflection of a communication signal at the end portion of the cable 300.

Further, the insulator 240 that insulates a communication unit 220 from the power supplied by the control unit 110 and has the insulating transformer 243 including the coils 243a, 243b is provided between the communication unit 220 and the cable 300. The filter circuit 260 including the capacitors 261, 262 is provided between the insulator 240 and the communication unit 220. The matching circuit 420 that includes the coil 421 (the coil 243a or the coil 243b) and the capacitor 422 (each of the capacitors 261, 262) and reduces reflection of a communication signal at the end portion of the cable 300 is formed between the communication unit 220 and the cable 300.

In this case, the matching circuit 420 is formed by the coils 243a, 243b of the insulator 240 and the capacitors 261, 262 of the filter circuit 260. That is, it is possible to form the matching circuit for reducing reflection of a communication signal at other end portion of the cable 300 by utilizing the circuit configuration for insulation and the circuit configuration for the filter circuit. Thus, the control device 100 and the driving device 200 can communicate with each other better while an increase in size of the connection structure of the communication system 400 is prevented. Further, it is possible to freely set the circuit constants of the coils 231, 232 and the capacitors 241, 242 forming the matching circuit 420 in the first embodiment by executing impedance matching using the coils 243a, 243b and the capacitors 261, 262.

The communication unit 220, the load 4 other than the matching circuit 420 between the communication unit 220 and the cable 300, and the matching circuit 420 form the interface circuit 2. Each of the coil 421 (the coil 243a or the coil 243b) and the capacitor 422 (each of the capacitors 261, 262) of the matching circuit 420 has a circuit constant that causes the impedance of the interface circuit 2 to match the characteristic impedance of the cable 300. In this case, the matching circuit 420 can easily reduce reflection of a communication signal at the end portion of the cable 300.

Specifically, each of the coil 421 and the capacitor 422 has a circuit constant that, at the center frequency of a communication signal, causes the real part of the complex impedance of the interface circuit 2 to coincide with the characteristic impedance of the cable 300 and causes the imaginary part of the complex impedance of the interface circuit 2 to be 0. In this case, the matching circuit 420 can more reliably reduce reflection of a communication signal at the end portion of the cable 300.

3. Other Embodiments

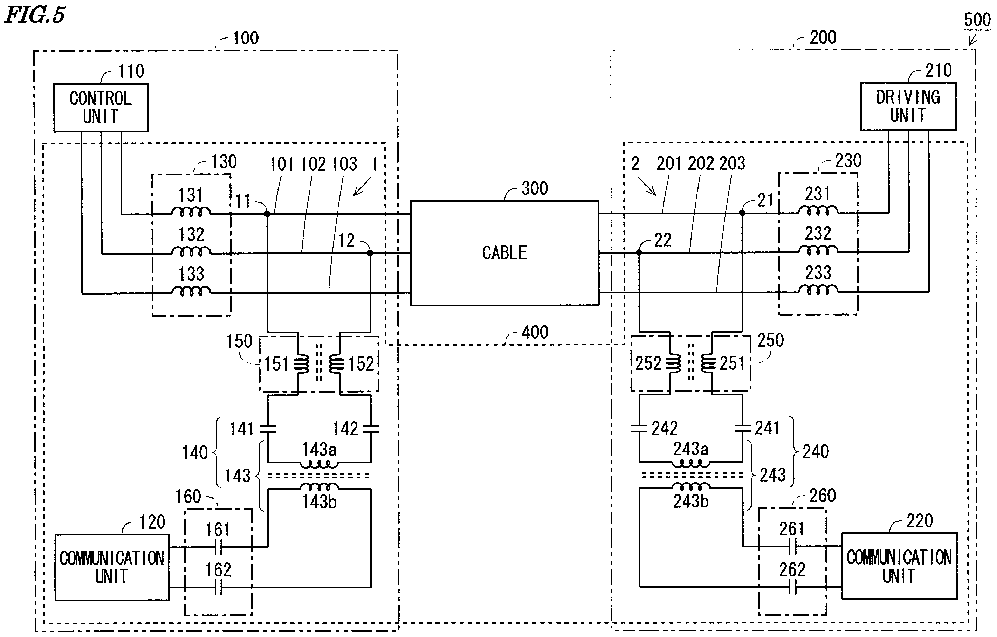

(1) While the cable 300 is a single-phase cable or a twisted-pair cable in the above-mentioned embodiment, the embodiment is not limited to this. The cable 300 may be a cable having another system. Fig. 5 is a diagram showing the configuration of a communication system 400 according to another embodiment. As shown in Fig. 5, in the present example, a cable 300 is a three-phase three-wire cable including three wires.

In this case, a control unit 110 is connected to one end portion of each of the three wires of the cable 300 by wires 101 to 103. Similarly, a driving unit 210 is connected to each of the other end portions of the three wires of the cable 300 by wires 201 to 203. Further, an impedance upper 130 further includes a coil 133 provided in the wire 103. An impedance upper 230 further includes a coil 233 provided in the wire 203. The other configuration of the communication system 400 is similar to the configuration of the communication system 400 of Fig. 1.

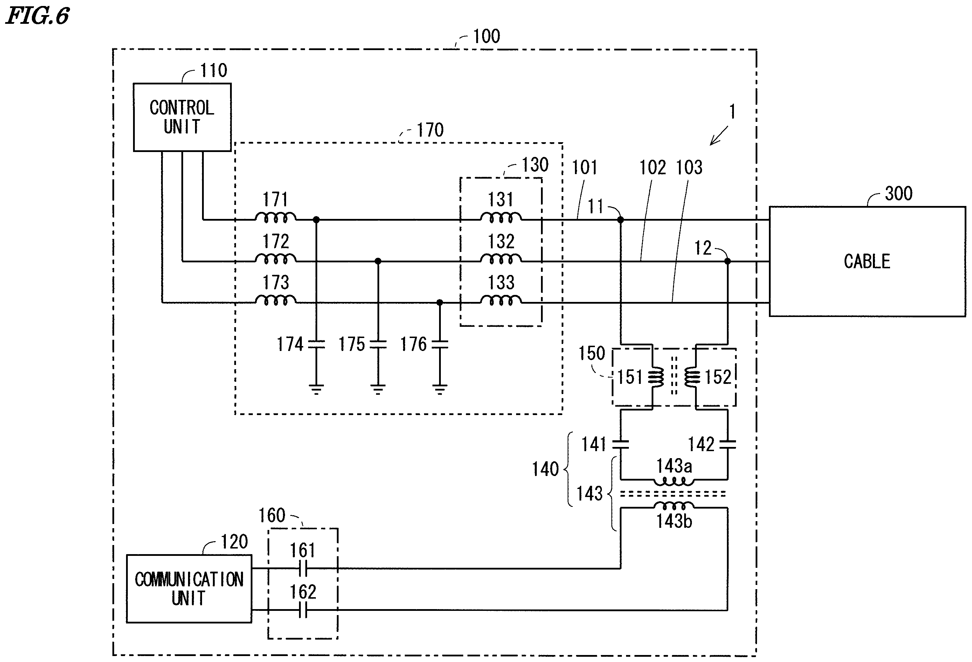

Further, similarly to the first modified example, a control device 100 of Fig. 5 may further include a low-pass filter 170. Fig. 6 is a diagram showing the configuration of a control device 100 in a second modified example. As shown in Fig. 6, in the present example, the low-pass filter 170 further includes a coil 173 and a capacitor 176, and further includes the coil 133. That is, the coil 133 of the impedance upper 130 forms part of the low-pass filter 170.

The coil 173 is connected between the coil 133 and the control unit 110. The capacitor 176 is connected between the portion between the coils 133, 173, and the ground potential. With this connection, the low-pass filter 170 forms a third-order low-pass filter. The capacitor 174 may be connected between a portion between the coils 131, 171 in the wire 101, and a portion between the coils 132, 172 in the wire 102. The capacitor 175 may be connected between a portion between the coils 132, 172 in the wire 102, and a portion between the coils 133, 173 in the wire 103. The capacitor 176 may be connected between a portion between the coils 133, 173 in the wire 103, and a portion between the coils 131, 171 in the wire 101. The other configuration of the control device 100 is similar to the configuration of the control device 100 of Fig. 4.

(2) In the above-mentioned embodiment, the control device 100 includes the CMCC 150, and the driving device 200 includes the CMCC 250. However, the embodiment is not limited to this. The control device 100 does not have to include the CMCC 150. The driving device 200 does not have to include the CMCC 250 either.

(3) While the control device 100 includes both of the impedance upper 130 and the filter circuit 160 in the above-mentioned embodiment, the embodiment is not limited to this. In the first embodiment, the control device 100 is only required to include the impedance upper 130 and does not have to include the filter circuit 160. Further, the insulator 140 is only required to include the capacitors 141, 142 and does not have to include the insulating transformer 143. On the other hand, in the second embodiment, the driving device 100 is only required to include the filter circuit 160 and does not have to include the impedance upper 130. Further, the insulator 140 is only required to include the insulating transformer 143 and does not have to include the capacitors 141, 142.

While the driving device 200 similarly includes both of the impedance upper 230 and the filter circuit 260 in the above-mentioned embodiment, the embodiment is not limited to this. In the first embodiment, the driving device 200 is only required to include the impedance upper 230 and does not have to include the filter circuit 260. Further, the insulator 240 is only required to include the capacitors 241, 242 and does not have to include the insulating transformer 243. On the other hand, in the second embodiment, the driving device 200 is only required to include the filter circuit 260 and does not have to include the impedance upper 230. Further, the insulator 240 is only required to include the insulating transformer 243 and does not have to include the capacitors 241, 242.

(4) While both of the matching circuits 410, 420 are provided in the communication system 400 in the above-mentioned embodiment, the embodiment is not limited to this. In the communication system 400, the matching circuit 410 may be provided, and the matching circuit 420 does not have to be provided. In this case, the driving device 200 does not have to include both of the impedance upper 230 and the filter circuit 260, and does not have to include the insulator 240. Alternatively, in the communication system 400, the matching circuit 420 may be provided, and the matching circuit 410 does not have to be provided. In this case, the control device 100 does not have to include both of the impedance upper 130 and the filter circuit 160, and does not have to include the insulator 140.

Further, in the communication system 400, the matching circuit 410 disclosed in the first embodiment and the matching circuit 420 disclosed in the second embodiment may be provided. Alternatively, in the communication system 400, the matching circuit 410 disclosed in the second embodiment and the matching circuit 420 disclosed in the first embodiment may be provided.

(5) While the low-pass filter 170 is a third-order low-pass filter in the above-mentioned embodiment, the embodiment is not limited to this. The low-pass filter 170 may be a first-order low-pass filter. In this case, the low-pass filter 170 does not include the coils 171 to 173 or the capacitors 174 to 176. Alternatively, the low-pass filter 170 may be a higher-order low-pass filter, such as a fifth or seventh order low-pass filter. In this case, the low-pass filter 170 further includes a circuit element in addition to the coils 131 to 133, 171 to 173 or the capacitors 174 to 176.

(6) The functionality of the elements disclosed herein may be implemented using circuitry or processing circuitry which includes general purpose processors, special purpose processors, integrated circuits, ASICs ("Application Specific Integrated Circuits"), conventional circuitry and/or combinations thereof which are configured or programmed to perform the disclosed functionality. Processors are considered processing circuitry or circuitry as they include transistors and other circuitry therein. In the disclosure, the circuitry, units, or means are hardware that carry out or are programmed to perform the recited functionality. The hardware may be any hardware disclosed herein or otherwise known which is programmed or configured to carry out the recited functionality. When the hardware is a processor which may be considered a type of circuitry, the circuitry, means, or units are a combination of hardware and software, the software being used to configure the hardware and/or processor.

4. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the cable 300 is an example of a cable, the control unit 110 is an example of a control circuitry, the communication unit 120 is an example of a first communication circuitry, and the driving unit 210 is an example of a driving circuitry. The communication unit 220 is an example of a second communication circuitry, the control system 500 is an example of a control system, the driving device 200 is an example of a driving device, and the coil 411 (each of the coils 131, 132 or each of the coils 143a, 143b) is an example of a first coil.

The impedance upper 130 is an example of a first impedance upper, and the capacitor 412 (each of the capacitors 141, 142 or each of the capacitors 161, 162) is an example of a first capacitor. The insulator 140 is an example of a first insulator, the matching circuit 410 is an example of a first matching circuit, the communication system 400 is an example of a communication system, the interface circuit 1 is an example of a first interface circuit, and the coil 421 (each of the coils 231, 232 or each of the coils 243a, 243b) is an example of a second coil. The impedance upper 230 is an example of a second impedance upper, and the capacitor 422 (each of the capacitors 241, 242 or each of the capacitors 261, 262) is an example of a second capacitor.

The insulator 240 is an example of a second insulator, the matching circuit 420 is an example of a second matching circuit, the interface circuit 2 is an example of a second interface circuit, the low-pass filter 170 is an example of a low-pass filter, and the coils 171, 172 are examples of a third coil. The capacitors 174, 175 are examples of a third capacitor, the filter circuit 160 is an example of a first filter circuit, and the filter circuit 260 is an example of a second filter circuit.

5. Overview of Embodiments

(Item 1) A communication system according to item 1 provided in a control system that includes a control circuitry configured to supply power through a cable having a predetermined characteristic impedance and a driving circuitry configured to receive power that is supplied through the cable, includes a first communication circuitry and a second communication circuitry configured to respectively receive or transmit communication signals indicating communication information through the cable from or to each other, a first impedance upper that is provided between one circuitry out of the control circuitry and the driving circuitry, and the cable, increases an impedance between the one circuitry and the cable, and includes a first coil, and a first insulator that is provided between one communication circuitry out of the first communication circuitry and the second communication circuitry, and the cable, insulates the one communication circuitry from power supplied by the control circuitry, and includes a first capacitor, wherein a first matching circuit that includes the first coil and the first capacitor and reduces reflection of the communication signal in an end portion of the cable is formed between the one communication circuitry and the cable.

In this communication system, the first matching circuit is formed by the first coil of the first impedance upper and the first capacitor of the first insulator. That is, it is possible to form the matching circuit for reducing reflection of a communication signal at the end portion of the cable by utilizing the circuit configuration for the impedance upper and the circuit configuration for insulation. Thus, the first communication circuitry and the second communication circuitry can communicate with each other well while an increase in size of the connection structure of the communication system is prevented.

(Item 2) The communication system according to item 1, wherein a first interface circuit that includes the first matching circuit between the one communication circuitry and the cable may be formed, and each of the first coil and the first capacitor may have a circuit constant that causes an impedance of the first interface circuit to match the characteristic impedance of the cable.

In this case, the first matching circuit can easily reduce reflection of a communication signal at the end portion of the cable.

(Item 3) The communication system according to item 2, wherein each of the first coil and the first capacitor may have a circuit constant that, at a center frequency of the communication signal, causes a real part of a complex impedance of the first interface circuit to coincide with the characteristic impedance of the cable and causes an imaginary part of the complex impedance of the first interface circuit to be 0.

In this case, the first matching circuit can more reliably reduce reflection of a communication signal at the end portion of the cable.

(Item 4) The communication system according to any one of items 1 to 3, may further include a second impedance upper that is provided between another circuitry out of the control circuitry and the driving circuitry, and the cable, increases an impedance between the another circuitry and the cable, and includes a second coil, and a second insulator that is provided between another communication circuitry out of the first communication circuitry and the second communication circuitry, insulates the another communication circuitry from power supplied by the control circuitry, and includes a second capacitor, wherein a second matching circuit that includes the second coil and the second capacitor and reduces reflection of the communication signal at an end portion of the cable is formed between the another communication circuitry and the cable.

In this case, the second matching circuit is formed by the second coil of the second impedance upper and the second capacitor of the second insulator. That is, it is possible to form the matching circuit for reducing reflection of a communication signal at the end portion of the cable by utilizing the circuit configuration for the impedance upper and the circuit configuration for insulation. Thus, the control device and the driving device can communicate with each other better while an increase in size of the connection structure of the communication system is prevented.

(Item 5) The communication system according to item 4, wherein a second interface circuit that includes the second matching circuit between the another communication circuitry and the cable may be formed, and each of the second coil and the second capacitor may have a circuit constant that causes an impedance of the second interface circuit to match the characteristic impedance of the cable.

In this case, the second matching circuit can easily reduce reflection of a communication signal at the end portion of the cable.

(Item 6) The communication system according to item 5, wherein each of the second coil and the second capacitor may have a circuit constant that, at a center frequency of the communication signal, causes a real part of a complex impedance of the second interface circuit to coincide with the characteristic impedance of the cable and causes an imaginary part of the complex impedance of the second interface circuit to be 0.

In this case, the second matching circuit can more reliably reduce reflection of a communication signal at the end portion of the cable.

(Item 7) The communication system according to any one of items 1 to 6, may further include a low-pass filter that is provided between the control circuitry and the first communication circuitry, wherein the first coil may form part of the low-pass filter.

In this case, part of the low-pass filter is formed by the first coil of the first impedance upper. Thus, the high-frequency component of the power supplied by the control circuitry is prevented from being input to the first communication circuitry. As a result, the control device and the driving device can communicate with each other better while an increase in size of the connection structure of the communication system is prevented.

(Item 8) The communication system according to item 7, wherein the low-pass filter may be a high-order low-pass filter that includes a third coil connected between the first coil and the control circuitry, and a third capacitor connected between a portion between the first coil and the third coil, and a predetermined potential.

In this case, the high-frequency component of the power supplied by the control circuitry is more reliably prevented from being input to the first communication circuitry.

(Item 9) A communication system according to item 9 provided in a control system that includes a control circuitry configured to supply power through a cable having a predetermined characteristic impedance and a driving circuitry configured to receive power that is supplied through the cable, includes a first communication circuitry and a second communication circuitry configured to respectively receive or transmit communication signals indicating communication information through the cable from or to each other, a first insulator that is provided between one communication circuitry out of the first communication circuitry and the second communication circuitry, and the cable, insulates the one communication circuitry from power supplied by the control circuitry, and includes a first coil, and a first filter circuit that is provided between the first insulator and the one communication circuitry and includes a first capacitor, wherein a first matching circuit that includes the first coil and the first capacitor and reduces reflection of the communication signal in an end portion of the cable is formed between the one communication circuitry and the cable.

In this communication system, the first matching circuit is formed by the first coil of the first insulator and the first capacitor of the first filter circuit. That is, it is possible to form the matching circuit for reducing reflection of a communication signal at the end portion of the cable by utilizing the circuit configuration for insulation and the circuit configuration for the filter circuit. Thus, the control device and the driving device can communicate with each other well while an increase in size of the connection structure of the communication system is prevented.

(Item 10) The communication system according to item 9, wherein a first interface circuit that includes the first matching circuit between the one communication circuitry and the cable may be formed, and each of the first coil and the first capacitor may have a circuit constant that causes an impedance of the first interface circuit to match the characteristic impedance of the cable.

In this case, the first matching circuit can easily reduce reflection of a communication signal at the end portion of the cable.

(Item 11) The communication system according to item 10, wherein each of the first coil and the first capacitor may have a circuit constant that, at a center frequency of the communication signal, causes a real part of a complex impedance of the first interface circuit to coincide with the characteristic impedance of the cable and causes an imaginary part of the complex impedance of the first interface circuit to be 0.

In this case, the first matching circuit can more reliably reduce reflection of a communication signal at the end portion of the cable.

(Item 12) The communication system according to any one of items 9 to 11, may further include a second insulator that is provided between another communication circuitry out of the first communication circuitry and the second communication circuitry, and the cable, insulates the another communication circuitry from power supplied by the control circuitry, and includes a second coil, and a second filter circuit that is provided between the second insulator and the another communication circuitry, and includes a second capacitor, wherein a second matching circuit that includes the second coil and the second capacitor and reduces reflection of the communication signal in an end portion of the cable may be formed between the another communication circuitry and the cable.

In this case, the second matching circuit is formed by the second coil of the second insulator and the second capacitor of the second filter circuit. That is, it is possible to form the matching circuit for reducing reflection of a communication signal at the end portion of the cable by utilizing the circuit configuration for insulation and the circuit configuration for the filter circuit. Thus, the control device and the driving device can communicate with each other better while an increase in size of the connection structure of the communication system is prevented.

(Item 13) The communication system according to item 12, wherein a second interface circuit that includes the second matching circuit between the another communication circuitry and the cable may be formed, and each of the second coil and the second capacitor may have a circuit constant that causes an impedance of the second interface circuit to match the characteristic impedance of the cable.

In this case, the second matching circuit can easily reduce reflection of a communication signal at the end portion of the cable.

(Item 14) The communication system according to item 13, wherein each of the second coil and the second capacitor may have a circuit constant that, at a center frequency of the communication signal, causes a real part of a complex impedance of the second interface circuit to coincide with the characteristic impedance of the cable and causes an imaginary part of complex impedance of the second interface circuit to be 0.

In this case, the second matching circuit can more reliably reduce reflection of a communication signal at the end portion of the cable.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

**Claims**

1. A communication system provided in a control system that includes a control circuitry configured to supply power through a cable having a predetermined characteristic impedance and a driving circuitry configured to receive power that is supplied through the cable, comprising:

   a first communication circuitry and a second communication circuitry configured to respectively receive or transmit communication signals indicating communication information through the cable from or to each other;
   a first impedance upper that is provided between one circuitry out of the control circuitry and the driving circuitry, and the cable, increases an impedance between the one circuitry and the cable, and includes a first coil; and
   a first insulator that is provided between one communication circuitry out of the first communication circuitry and the second communication circuitry, and the cable, insulates the one communication circuitry from power supplied by the control circuitry, and includes a first capacitor, wherein
   a first matching circuit that includes the first coil and the first capacitor and reduces reflection of the communication signal in an end portion of the cable is formed between the one communication circuitry and the cable.

2. The communication system according to claim 1, wherein

   a first interface circuit that includes the first matching circuit between the one communication circuitry and the cable is formed, and
   each of the first coil and the first capacitor has a circuit constant that causes an impedance of the first interface circuit to match the characteristic impedance of the cable.

3. The communication system according to claim 2, wherein
   each of the first coil and the first capacitor has a circuit constant that, at a center frequency of the communication signal, causes a real part of a complex impedance of the first interface circuit to coincide with the characteristic impedance of the cable and causes an imaginary part of the complex impedance of the first interface circuit to be 0.

4. The communication system according to any one of claims 1 to 3, further comprising:

a second impedance upper that is provided between another circuitry out of the control circuitry and the driving circuitry, and the cable, increases an impedance between the another circuitry and the cable, and includes a second coil; and

a second insulator that is provided between another communication circuitry out of the first communication circuitry and the second communication circuitry, insulates the another communication circuitry from power supplied by the control circuitry, and includes a second capacitor, wherein

a second matching circuit that includes the second coil and the second capacitor and reduces reflection of the communication signal at an end portion of the cable is formed between the another communication circuitry and the cable.

5. The communication system according to claim 4, wherein

a second interface circuit that includes the second matching circuit between the another communication circuitry and the cable is formed, and

each of the second coil and the second capacitor has a circuit constant that causes an impedance of the second interface circuit to match the characteristic impedance of the cable.

6. The communication system according to claim 5, wherein
each of the second coil and the second capacitor has a circuit constant that, at a center frequency of the communication signal, causes a real part of a complex impedance of the second interface circuit to coincide with the characteristic impedance of the cable and causes an imaginary part of the complex impedance of the second interface circuit to be 0.

7. The communication system according to any one of claims 1 to 6, further comprising a low-pass filter that is provided between the control circuitry and the first communication circuitry, wherein
the first coil forms part of the low-pass filter.

8. The communication system according to claim 7, wherein

the low-pass filter is a high-order low-pass filter that includes
a third coil connected between the first coil and the control circuitry, and
a third capacitor connected between a portion between the first coil and the third coil, and a predetermined potential.

9. A communication system provided in a control system that includes a control circuitry configured to supply power through a cable having a predetermined characteristic impedance and a driving circuitry configured to receive power that is supplied through the cable, comprising:

a first communication circuitry and a second communication circuitry configured to respectively receive or transmit communication signals indicating communication information through the cable from or to each other;

a first insulator that is provided between one communication circuitry out of the first communication circuitry and the second communication circuitry, and the cable, insulates the one communication circuitry from power supplied by the control circuitry, and includes a first coil; and

a first filter circuit that is provided between the first insulator and the one communication circuitry and includes a first capacitor, wherein

a first matching circuit that includes the first coil and the first capacitor and reduces reflection of the communication signal in an end portion of the cable is formed between the one communication circuitry and the cable.

10. The communication system according to claim 9, wherein

a first interface circuit that includes the first matching circuit between the one communication circuitry and the cable is formed, and

each of the first coil and the first capacitor has a circuit constant that causes an impedance of the first interface circuit to match the characteristic impedance of the cable.

11. The communication system according to claim 10, wherein

each of the first coil and the first capacitor has a circuit constant that, at a center frequency of the communication signal, causes a real part of a complex impedance of the first interface circuit to coincide with the characteristic impedance of the cable and causes an imaginary part of the complex impedance of the first interface circuit to be 0.

12. The communication system according to any one of claims 9 to 11, further comprising:

a second insulator that is provided between another communication circuitry out of the first communication circuitry and the second communication circuitry, and the cable, insulates the another communication circuitry from power supplied by the control circuitry, and includes a second coil; and
a second filter circuit that is provided between the second insulator and the another communication circuitry, and includes a second capacitor, wherein
a second matching circuit that includes the second coil and the second capacitor and reduces reflection of the communication signal in an end portion of the cable is formed between the another communication circuitry and the cable.

13. The communication system according to claim 12, wherein

a second interface circuit that includes the second matching circuit between the another communication circuitry and the cable is formed, and
each of the second coil and the second capacitor has a circuit constant that causes an impedance of the second interface circuit to match the characteristic impedance of the cable.

14. The communication system according to claim 13, wherein
each of the second coil and the second capacitor has a circuit constant that, at a center frequency of the communication signal, causes a real part of a complex impedance of the second interface circuit to coincide with the characteristic impedance of the cable and causes an imaginary part of complex impedance of the second interface circuit to be 0.

FIG.1

FIG.2

FIG.3

EP 4 625 833 A1

FIG.4

EP 4 625 833 A1

**FIG.5**

*FIG.6*

EP 4 625 833 A1

Europäisches
Patentamt

European
Patent Office

Office européen
des brevets

# EUROPEAN SEARCH REPORT

**Application Number**

EP 25 16 5685

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/041359 A1 (PRUESSMEIER UWE [DE] ET AL) 8 February 2018 (2018-02-08) * figure 1 * | 1,9 | INV. H04B3/56 |
| A | CN 103 635 360 B (SUMITOMO ELECTRIC INDUSTRIES; SUNITOMO WIRING SYSTEMS LTD ET AL.) 20 April 2016 (2016-04-20) * figure 9 * | 1-14 | |

**TECHNICAL FIELDS SEARCHED (IPC)**

H04B

The present search report has been drawn up for all claims

| Place of search | Date of completion of the search | Examiner |
|---|---|---|
| The Hague | 24 July 2025 | De Iulis, M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 5685

This annex lists the patent family members relating to the patent documents cited in the above-mentioned European search report.
The members are as contained in the European Patent Office EDP file on
The European Patent Office is in no way liable for these particulars which are merely given for the purpose of information.

24-07-2025

| Patent document cited in search report | Publication date | Patent family member(s) | Publication date |
|---|---|---|---|
| US 2018041359 A1 | 08-02-2018 | CN 107820691 A | 20-03-2018 |
| | | DE 102015105702 B3 | 04-08-2016 |
| | | EP 3284210 A1 | 21-02-2018 |
| | | US 2018041359 A1 | 08-02-2018 |
| | | WO 2016166143 A1 | 20-10-2016 |
| CN 103635360 B | 20-04-2016 | CN 103635360 A | 12-03-2014 |
| | | EP 2724894 A1 | 30-04-2014 |
| | | JP 5931863 B2 | 08-06-2016 |
| | | JP WO2012176832 A1 | 23-02-2015 |
| | | US 2014254694 A1 | 11-09-2014 |
| | | WO 2012176832 A1 | 27-12-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007150621 A